# EUROPÄISCHE PATENTSCHRIFT

(11) **EP 2 715 871 B1**
(45) Veröffentlichungstag und Bekanntmachung des Hinweises auf die Patenterteilung: **09.10.2019**
(21) Anmeldenummer: 12723855.8
(22) Anmeldetag: 21.05.2012
(51) Int. Cl.: G01R 1/04, G01R 1/073, H01R 9/26

(54) **PRÜF- UND ANSCHLUSSVORRICHTUNGSANORDNUNG**
TEST AND CONNECTION APPARATUS ARRANGEMENT
DISPOSITIF DE CONTRÔLE ET DE CONNEXION

(30) Priorität: 03.06.2011 DE 202011101414 U
(43) Veröffentlichungstag der Anmeldung: 09.04.2014
(73) Patentinhaber: Weidmüller Interface GmbH & Co. KG, 32758 Detmold (DE)
(72) Erfinder: HACKEMACK, Frank, 32758 Detmold (DE); RICHTS, Jörg, 33189 Schlangen (DE); JASCHKE, Bernhard, 32791 Lage (DE)
(74) Vertreter: Specht, Peter
(86) Internationale Anmeldenummer: PCT/EP2012/059383
(87) Internationale Veröffentlichungsnummer: WO 2012/163713

(56) Entgegenhaltungen:
- WO-A1-2012/022483
- DE-A1-102006 052 894
- DE-U1- 29 917 825

## Beschreibung

Die Erfindung betrifft eine Prüf- und Anschlussvorrichtungsanordnung nach dem Oberbegriff des Anspruchs 1.

Eine derartige Anordnung beinhaltet eine Anschlussvorrichtung zum Anschluss von elektrischen Leitern und eine Prüfvorrichtung, welche mit der Anschlussvorrichtung verbindbar ist, um elektrische Größen, die mit den angeschlossenen elektrischen Leitern und damit verbundenen elektrischen Geräten in Zusammenhang stehen, zu prüfen und zu messen. Dabei werden Mess- und Prüfvorgänge ohne Veränderung der bestehenden Stromkreise vorgenommen. Zum Stand der Technik wird auf die DE 10 2006 052 894 A1 verweisen, die eine gattungsgemäße Anordnung zeigt.

Ein kontinuierlich steigender Bedarf für derartige Anordnungen, z.B. in Automatisierungsbereichen, ergibt die Forderung nach verbesserten Funktionsgruppen sowie vergrößertem Einsatzbereich.

Die Aufgabe der Erfindung ist es daher, eine verbesserte Anordnung bereitzustellen.

Diese Aufgabe wird durch eine Prüf- und Anschlussvorrichtungsanordnung mit den Merkmalen des Anspruchs 1 gelöst.

Die Anordnung ermöglicht die Vorteile von Mess- und Prüfvorgängen außerhalb des Produkts, in welches die Anschlussvorrichtung eingebunden ist bei gleichzeitiger Erhöhung von Anschlussmöglichkeiten der Prüfvorrichtung.

Bei einer erfindungsgemäßen Prüf- und Anschlussvorrichtungsanordnung, mit einer Prüfvorrichtung, und mit einer Anschlussvorrichtung zum Anschluss von elektrischen Leitern, bei der die Prüfvorrichtung in die Anschlussvorrichtung einsteckbar ist und dabei eine elektrische Verbindung zwischen zwei sich elektrisch kontaktierenden Kontaktfahnen trennt, ist die Prüfvorrichtung von einer Oberseite der Anschlussvorrichtung und von einer Unterseite der Anschlussvorrichtung in die Anschlussvorrichtung einsteckbar. Und zwar ist erfindungsgemäß vorgesehen, dass die Prüfvorrichtung entweder von einer Oberseite der Anschlussvorrichtung oder von einer Unterseite der Anschlussvorrichtung in diese eingesteckt ist.

Dadurch ist es möglich, die Anordnung vielseitiger einzusetzen.

Erfindungsgemäß weist die Anschlussvorrichtung sowohl an ihrer Oberseite als auch an ihrer Unterseite zwei sich elektrisch kontaktierende Kontaktfahnen auf.

Die zwei an der Oberseite angeordneten und die zwei an der Unterseite angeordneten Kontaktfahnen sind dabei bevorzugt übereinander angeordnet. Und zwar ist die Anschlussvorrichtung in Bezug auf die Kontaktfahnen vorzugsweise symmetrisch vorgesehen. Dies ermöglicht das Einstecken der Prüfvorrichtung sowohl von der Oberseite der Anschlussvorrichtung als auch von ihrer Unterseite, ohne dafür eine zusätzliche oder umständliche konstruktive Anpassung der Anschlussvorrichtung vornehmen zu müssen.

Besonders bevorzugt sind die zwei an der Oberseite angeordneten und die zwei an der Unterseite angeordneten Kontaktfahnen elektrisch parallel geschaltet. Auch in elektrischer Hinsicht sind daher zum Einstecken und Anschließen der Prüfvorrichtung entweder von der Oberseite oder der Unterseite jeweils keine konstruktiven Anpassungen der Anschlussvorrichtung erforderlich. Zudem ist dies in einfacher Weise innerhalb der Anschlussvorrichtung möglich, wodurch diese in ihrem Volumen nicht vergrößert wird.

Um ein fehlerhaftes Anschließen der Prüfvorrichtung, insbesondere ein Überbrücken der Prüfvorrichtung, zu vermeiden, ist ferner nach Anspruch 1 auch ein elektrisch isolierendes Steckelement bei der Anordnung vorgesehen. Es ist vorgesehen, dass das Steckelement bei von der Oberseite der Anschlussvorrichtung in diese eingesteckter Prüfvorrichtung die an der Unterseite der Anschlussvorrichtung angeordneten sich elektrisch kontaktierenden Kontaktfahnen elektrisch trennt, wobei das Steckelement bei von der Unterseite der Anschlussvorrichtung in diese eingesteckter Prüfvorrichtung die an der Oberseite der Anschlussvorrichtung angeordneten sich elektrisch kontaktierenden Kontaktfahnen elektrisch trennt. Dieses wieder entfernbare Steckelement ermöglicht es, die Anschlussvorrichtung je nach Position der Prüfvorrichtung an der Oberseite oder an der Unterseite der Anschlussvorrichtung durch Umstecken anzupassen, ohne weitere konstruktive Anpassungen zu erfordern.

Es ist besonders bevorzugt, dass das Steckelement unlösbar in der Anschlussvorrichtung angeordnet ist. Prinzipiell ist aber auch eine Ausführungsform denkbar, bei der das Steckelement lösbar in die Anschlussvorrichtung eingesteckt ist. In dieser letztgenannten Ausführungsform ist es jedoch bevorzugt, dass es bei montierter Anschlussvorrichtung schwer zugänglich oder nur aufwendig aus der Anschlussvorrichtung lösbar ist.

Zu diesem Zweck weist das Steckelement bevorzugt ein Verrastmittel auf, mit dem es im der Anschlussvorrichtung verrastbar ist. Die Anschlussvorrichtung weist dafür bevorzugt ein Gegenverrastmittel auf, welches in einer besonders bevorzugten Ausführungsform das Gehäuse der Anschlussvorrichtung ist. Beim Einstecken verrastet das Verrastmittel mit dem Gegenverrastmittel, so dass es entweder unlösbar oder nur schwer lösbar, beispielsweise durch Teildemontage der Anschlussvorrichtung oder zumindest mit zusätzlichem Werkzeug, in der Anschlussvorrichtung verrastet ist.

In einer noch weiteren Ausführung weist die Anschlussvorrichtung mindestens ein Schutzelement auf, welches aus einer ersten Stellung, in welcher es Betätigungsabschnitte für darunter angeordnete Klemmeinheiten der Anschlussvorrichtung verschließt, in eine zweite Stellung verstellbar ist, in welcher die Betätigungsabschnitte zugänglich sind, bringbar ist. Damit ist ein einfacher und schneller Manipulationsschutz ermöglicht.

In einer weiteren Ausführung ist das mindestens eine Schutzelement in einer Führung eines Gehäuses der Anschlussvorrichtung in Längsrichtung der Anschlussvorrichtung verschiebbar gehalten. Eine solche Ausgestaltung ist einfach und dabei kann das Schutzelement leicht und schnell verstellt werden.

Es ist dabei vorgesehen, dass das mindestens eine Schutzelement jeweils ein Abdeckfeld mit einer Abdecköffnung pro Klemmeinheit aufweist. Auf diese Weise kann ein Schutzelement für eine bestimmte Anzahl von Klemmeinheiten durch einfaches Ablängen angepasst werden.

In einer noch weiteren Ausführung ist die Anschlussvorrichtung für eine Tragschienenmontage und/oder eine Wandmontage vorgesehen. Dadurch wird ein vielseitiger Einsatzbereich geschaffen.

In einer weiteren Ausführung weist die Anschlussvorrichtung der Prüf- und Anschlussvorrichtungsanordnung mindestens zwei anbringbare Halter auf, welche jeweils Tragschienenhalteabschnitte für eine Tragschienenmontage der Anschlussvorrichtung und Wandhalteabschnitte für eine Wandmontage der Anschlussvorrichtung aufweisen.

Die anbringbaren Halter können z.B. in die Unterseite des Gehäuses der Anschlussvorrichtung in dafür vorgesehene Aufnahmen oder Ausnehmungen eingesteckt und verrastet werden, um die Anschlussvorrichtung sowohl an einer Tragschiene als auch an einem Wandelement festzulegen. Dadurch ist eine vielseitige Montagemöglichkeit mit gleichen Haltern geschaffen.

In einer alternativen nicht erfindungsgemäßen Ausführung kann die Anschlussvorrichtung, welche zum Anschluss von elektrischen Leitern ausgebildet ist mindestens zwei anbringbare Halter umfassen, welche jeweils Tragschienenhalteabschnitte für eine Tragschienenmontage der Anschlussvorrichtung und Wandhalteabschnitte für eine Wandmontage der Anschlussvorrichtung aufweisen.

Eine noch weitere nicht erfindungsgemäße Ausführung sieht vor, dass die Anschlussvorrichtung zum beidseitigen Einstecken einer Prüfvorrichtung von einer Oberseite der Anschlussvorrichtung und einer Unterseite der Anschlussvorrichtung mit ersten und zweiten Kontaktfahnen ausgebildet ist.

Eine Anschlussvorrichtung, welche zum Anschluss von elektrischen Leitern ausgebildet ist, ist zum beidseitigen Einstecken einer Prüfvorrichtung von einer Oberseite der Anschlussvorrichtung und einer Unterseite der Anschlussvorrichtung mit ersten und zweiten Druckfedern ausgebildet.

Anhand einer beispielhaften Ausführung wird die Erfindung mit Bezug auf die beigefügten Zeichnungen näher erläutert. Hierbei zeigen:
- Figur 1: eine schematische Schnittansicht eines ersten Ausführungsbeispiels einer erfindungsgemäßen Anordnung mit an einer Tragschiene angeordneter Anschlussvorrichtung;
- Figur 2: eine schematische Schnittansicht eines zweiten Ausführungsbeispiels der erfindungsgemäßen Anordnung mit an einem Wandelement angeordneter Anschlussvorrichtung;
- Figur 3: eine schematische Schnittansicht eines weiteren Ausführungsbeispiels einer erfindungsgemäßen Anordnung mit analog der Figur 2 an einem Wandelement angeordneter Anschlussvorrichtung, in der Kontaktfahnen sichtbar sind;
- Figur 4: in (a) eine schematische Perspektivansicht eines Ausführungsbeispiels einer erfindungsgemäßen Anschlussvorrichtung mit einem Manipulationsschutz in einer ersten Stellung, und in (b) eine schematische Perspektivansicht eines weiteren Ausführungsbeispiels einer erfindungsgemäßen Anschlussvorrichtung während eines Montagezustandes;
- Figur 5: das Ausführungsbeispiel nach Figur 4 mit dem Manipulationsschutz in einer zweiten Stellung;
- Figur 6: eine schematische Perspektivansicht eines Ausführungsbeispiels der erfindungsgemäßen Anschlussvorrichtung bei Tragschienenmontage von unten; und
- Figur 7: eine schematische Perspektivansicht eines Ausführungsbeispiels der erfindungsgemäßen Anschlussvorrichtung bei Wandmontage von unten.

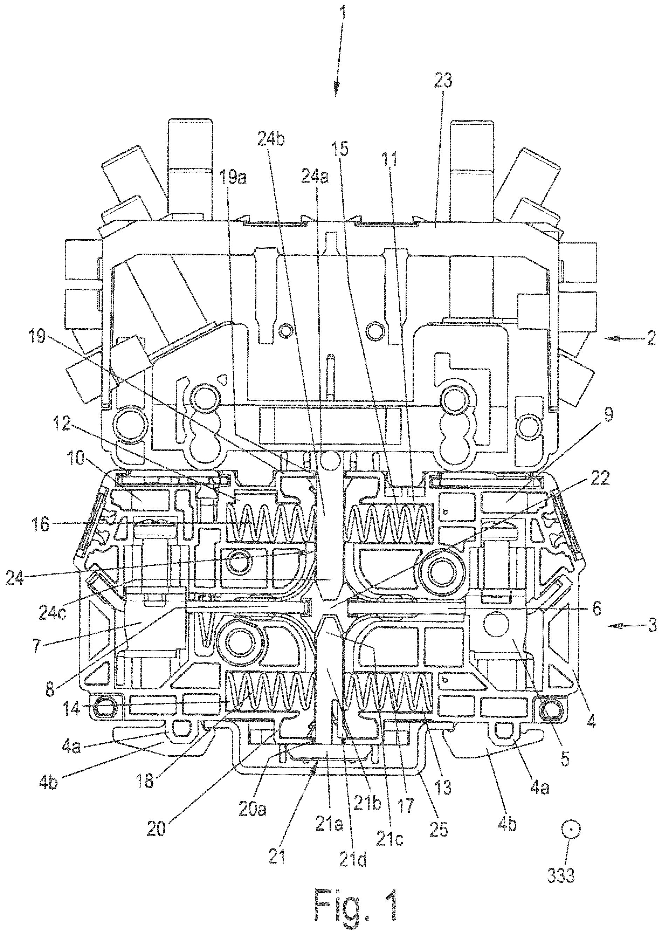

Figur 1 zeigt eine schematische Schnittansicht eines ersten Ausführungsbeispiels einer erfindungsgemäßen Anordnung 1.

Die Anordnung 1 ist eine Prüf- und Anschlussvorrichtungsanordnung und umfasst eine Prüfvorrichtung 2 und eine Anschlussvorrichtung 3.

Die Prüfvorrichtung 2 ist zum Einstecken in die Anschlussvorrichtung 3 vorgesehen und dient zur Prüfung und Messung elektrischer Werte von an der Anschlussvorrichtung 3 angeschlossenen elektrischen Geräten, die nicht näher beschrieben werden sollen.

Die Prüfvorrichtung 2 weist ein Prüfvorrichtungsgehäuse 23 auf und ist nicht näher dargestellt. In dem Gehäuse sind nicht weiter beschriebene Steck- und Schalteinrichtungen für Prüf- und/oder Messzwecke angeordnet. An der Unterseite der Prüfvorrichtung 2 sind Stiftelemente 24 angebracht, von denen hier beispielhaft stellvertretend für alle anderen nur eines gezeigt ist. Mit diesen Stiftelementen 24 und gegebenenfalls weiteren Steckern, auf die nicht weiter eingegangen werden soll, wird die Prüfvorrichtung 2 in die Anschlussvorrichtung 3 eingesteckt.

In diesem ersten Ausführungsbeispiel ist die Anschlussvorrichtung 3 für die Montage auf einer Tragschiene 25 vorgesehen und mit ihrer Unterseite auf dieser in Längsrichtung 333 der Anschlussvorrichtung 3 befestigt, z.B. wie hier gezeigt mittels Halter 4b. Die Halter 4b werden weiter unten noch weiter beschrieben. Die Prüfvorrichtung 2 ist von der Oberseite der Anschlussvorrichtung 3 her in die Anschlussvorrichtung 3 eingesteckt gezeigt.

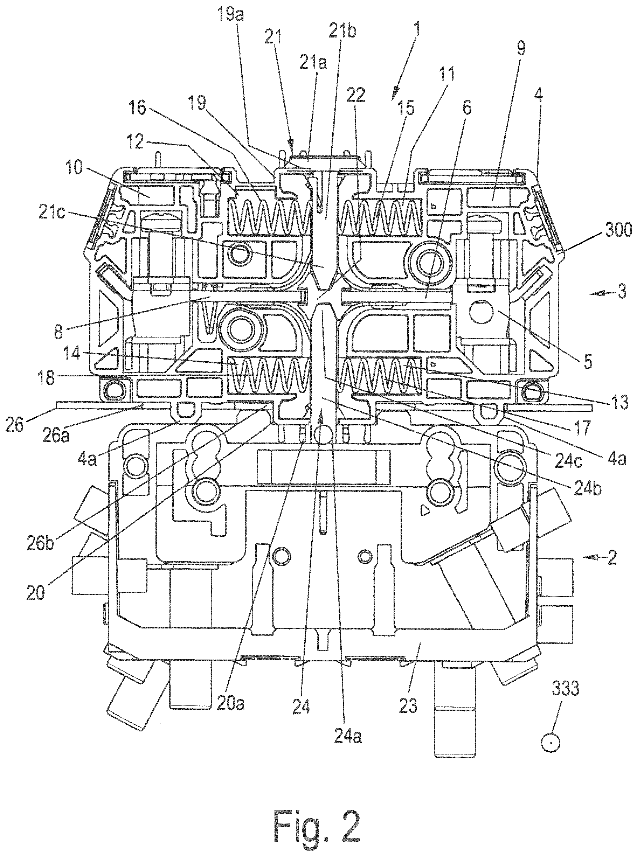

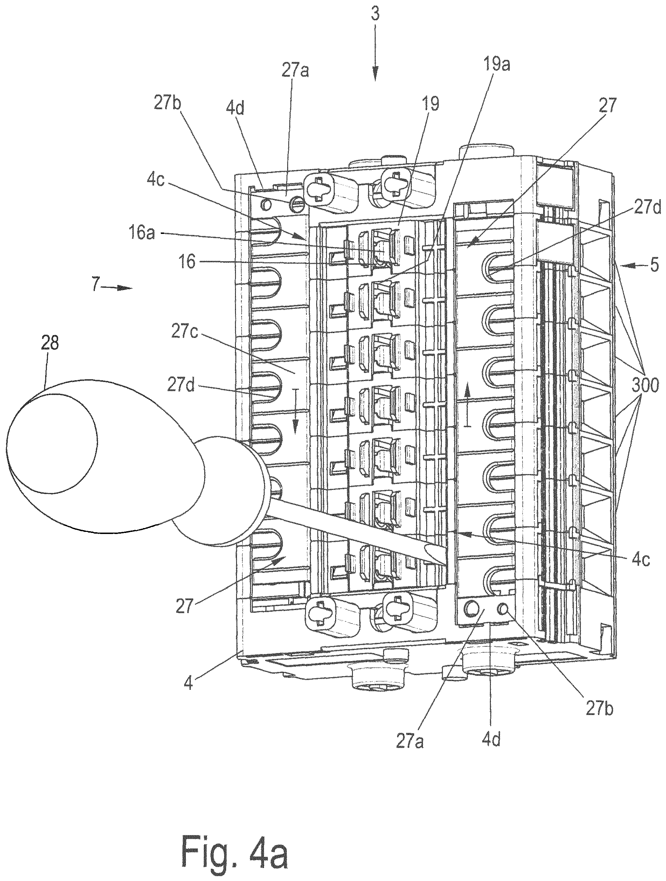

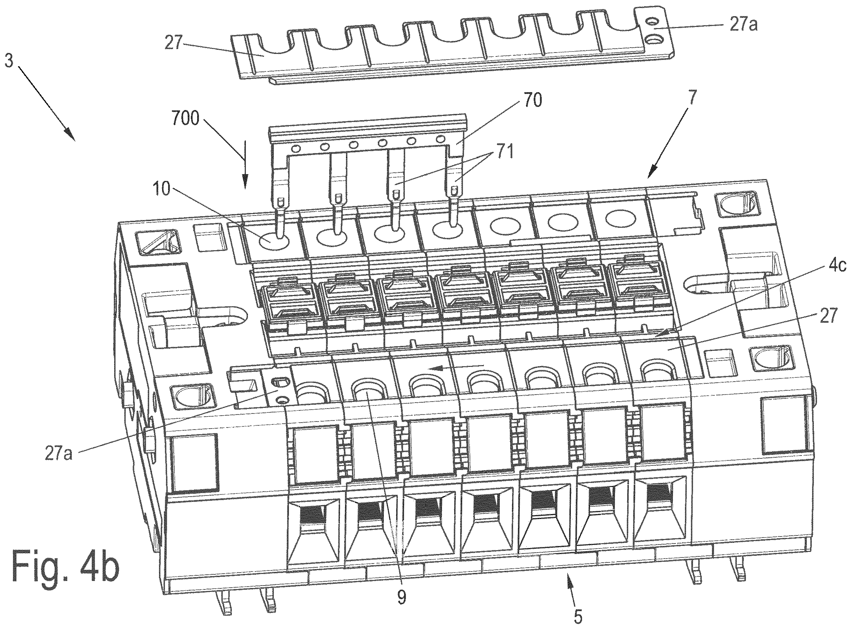

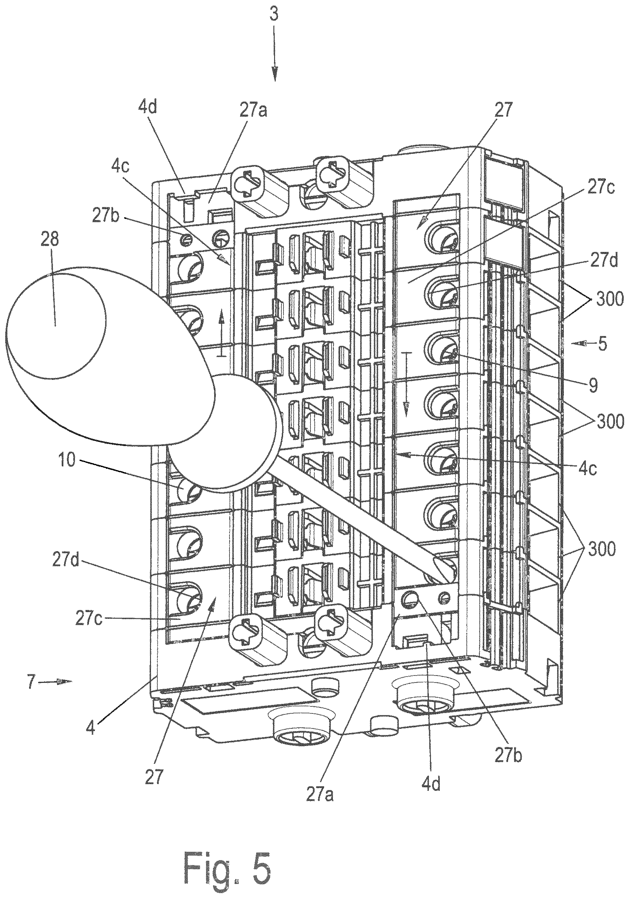

Die Anschlussvorrichtung 3 weist in diesem Ausführungsbeispiel (siehe Figur 4 und 5) sieben nebeneinander angeordnete Klemm- bzw. Anschlusseinheiten 300 auf, von denen in Figur 1 und 2 eine mit ihrem Gehäuse 4 stellvertretend für die anderen im Schnitt gezeigt ist. Die Anschlusseinheiten 300 dienen jeweils zum Anschluss elektrischer Leitungen, die im Wesentlichen rechtwinklig zur Längsachse der Anschlussvorrichtung 3 (welche in Figur 1 und 2 senkrecht auf der Zeichnungsebene steht) beidseitig in die Anschlusseinheiten 300 einführbar und in Klemmeinheiten 5 und 7 befestigbar sind. Die Klemmeinheiten 5 und 7 sind in diesem Ausführungsbeispiel als ein Paar gezeigt, selbstverständlich sind auch größere Paarzahlen möglich. Die Klemmeinheiten 5 und 7 sind hier mit Schrauben versehen, welche durch einen jeweiligen Betätigungsabschnitt 9, 10 von der Oberseite der Anschlussvorrichtung 3 her erreichbar sind. Die Klemmeinheit 5 ist mit einer Stromschiene 6 verbunden, wobei die gegenüberliegende Klemmeinheit 7 spiegelbildlich mit einer Stromschiene 8 verbunden ist. Die Stromschienen 6 und 8 liegen in einer Ebene und sind elektrisch voneinander isoliert in einem Trennelement 22 aufgenommen.

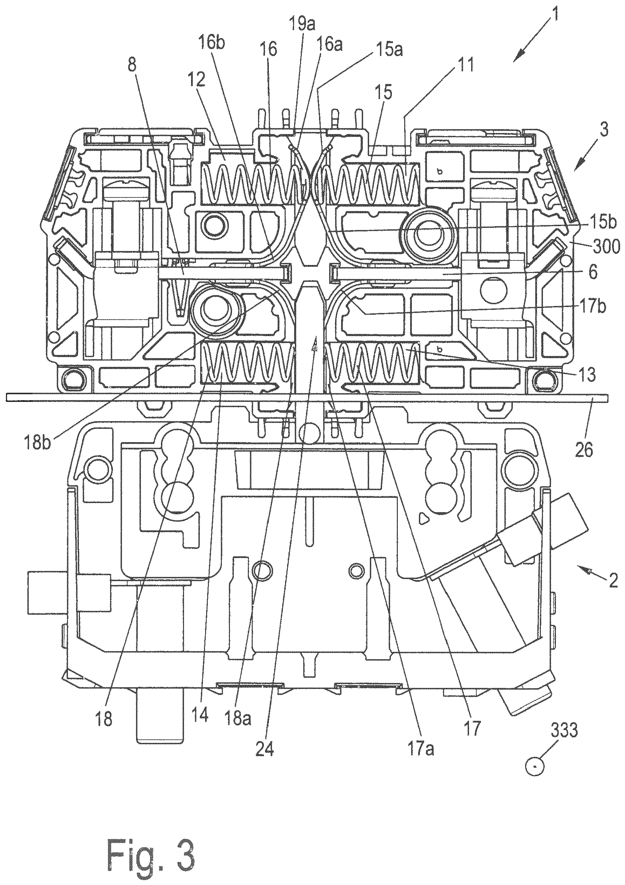

Oberhalb der Stromschiene 6 ist in dem Gehäuse 4 eine erste Kammer 11 zur Aufnahme einer ersten Druckfeder 15 angeordnet. Auf der linken Seite ist auf gleicher Höhe eine weitere erste Kammer 12 zur Aufnahme einer weiteren ersten Druckfeder 16 eingeformt. Jede erste Druckfeder 15, 16 wirkt mit einer ersten Kontaktfahne 15a, 16a zusammen (siehe Figur 3), welche zwischen den ersten Druckfeder 15, 16 angeordnet sind. In der Figur 1 befindet sich zwischen den ersten Kontaktfahnen 15a, 16a (die hier nicht zu sehen sind, siehe Figur 3) und den Druckfedern das eingesteckte Stiftelement 24 der Prüfvorrichtung 2, auf welches unten noch näher eingegangen wird. Ohne eingestecktes Stiftelement 24, d.h. ohne eingesteckte Prüfvorrichtung 2, drücken die beiden ersten Druckfedern 15 und 16 die ersten Kontaktfahnen 15a, 16a gegeneinander (Figur 3) und stellen zwischen diesen einen elektrisch leitenden Kontakt her, der bei eingesteckter Prüfvorrichtung 2 (wie in Figur 1 gezeigt) durch das Stiftelement 24 unterbrochen ist.

Das Stiftelement 24 ist mit einer Verbindung 24a an der Unterseite des Prüfvorrichtungsgehäuses 23 angebracht oder mit diesem einstückig ausgebildet. Es steht stellvertretend für weitere. An die Verbindung 24a schließt sich ein Stiftkörper 24b mit einer Stiftspitze 24c an. Das Stiftelement 24 der Prüfvorrichtung 2 ist durch eine erste Öffnung 19a eines ersten Öffnungsabschnitts 19 des Gehäuses 4 der Anschlussvorrichtung 3 hindurch zwischen die ersten Druckfedern 15 und 16 gesteckt. Der erste Öffnungsabschnitt 19 befindet sich an der Oberseite des Gehäuses 4 der Anschlussvorrichtung 3. Die Stiftspitze 24c dient beim Einstecken zum Einfädeln und Auseinanderdrücken der ersten Kontaktfahnen 15a und 16a der ersten Druckfedern 15 und 16 und ist im eingesteckten Zustand in dem Trennelement 22 aufgenommen, welches dazu eine Aufnahme aufweist, die mit der Stiftspitze 24c korrespondiert. Im eingesteckten Zustand ruhen die ersten Kontaktfahnen 15a und 16a gedrückt durch die ersten Druckfedern 15 und 16 mit ihren durch das Stiftelement 24 getrennten Kontaktabschnitten an dem Stiftkörper 24b, welcher in einer bevorzugten Ausführungsform elektrisch isolierend ausgebildet ist. Beim Einstecken des Stiftkörper 24b zwischen die Kontaktfahnen 15a, 16a trennt der Stiftkörper 24b daher die elektrische Verbindung zwischen den Kontaktfahnen 15a, 16a. Besonders bevorzugt sind am Stiftkörper 24b aber jeweils an der den Kontaktfahnen 15a, 16a zugewandten Seite elektrisch leitende Kontaktplatten (nicht gezeigt) angeordnet, die eine jeweils an den Kontaktfahnen 15a, 16a anliegende Spannung abgreifen, so dass ein über die Kontaktfahnen 15a, 16a fließender Stromkreis zwar unterbrochen wird. In der oder über die Prüfvorrichtung 2 sind die Kontaktplatten jedoch mit verschiedenen Messmetern (nicht gezeigt) verbindbar, so dass beispielsweise die an den Kontaktfahnen 15a, 16a anliegende Spannung, der über die Kontaktfahnen 15a, 16a fließende Strom, eine Frequenz, eine Leistung, ein Widerstand oder ähnlich messbar sind.

Die ersten Druckfedern 15 und 16 sind in den ersten Kammern 11 und 12 unter Vorspannung eingesetzt, sodass ein bestimmter Kontaktdruck der ersten Kontaktfahnen 15a und 16a bei ihrer Kontaktierung vorhanden ist.

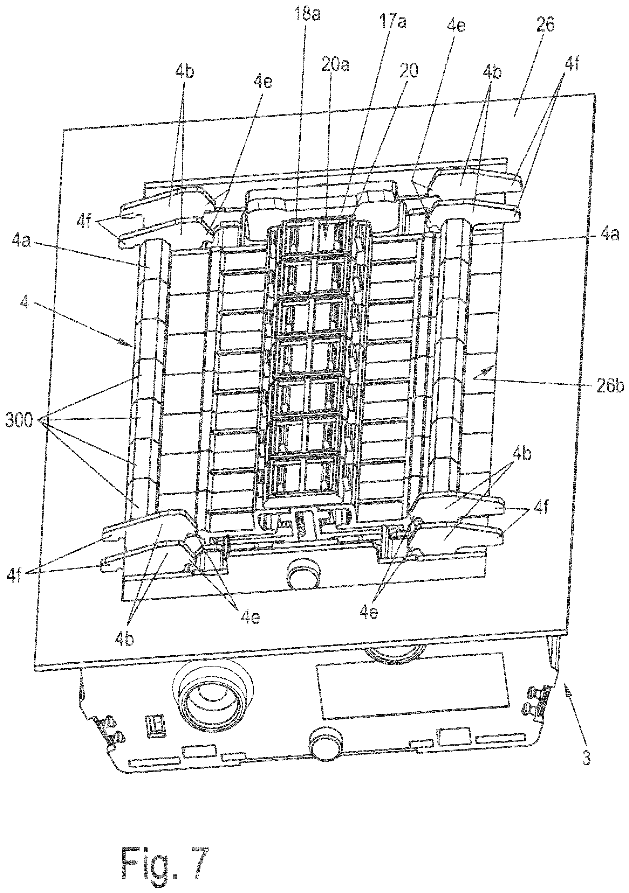

In gleicher Weise ist unterhalb der Stromschiene 6 in dem Gehäuse 4 eine zweite Kammer 13 mit einer zweiten Druckfeder 17 angeordnet. Auf der linken Seite ist auf gleicher Höhe eine weitere zweite Kammer 14 zur Aufnahme einer weiteren zweiten Druckfeder 18 eingeformt. Den zweiten Druckfedern 17 und 18 sind wie den ersten Druckfedern 15 und 16 zweite Kontaktfahnen 17a und 18a zugeordnet (siehe Figur 3 und 7). Die zweiten Druckfedern 17 und 18 sind elektrisch mit den ersten Druckfedern 15, 16 parallel geschaltet. Damit bei eingesteckter Prüfvorrichtung 2 auch ein elektrischer Kontakt der zweiten Kontaktfahnen 17a und 18a der zweiten Druckfedern 17, 18 untereinander unterbrochen wird, ist zwischen den Kontaktabschnitten der zweiten Kontaktfahnen 17a und 18a der zweiten Druckfedern 17, 18 ein Steckelement 21 eingesetzt.

Auch die zweiten Druckfedern 17 und 18 sind in den zweiten Kammern 13 und 14 unter Vorspannung eingesetzt, um einen bestimmten Kontaktdruck bei der Kontaktierung der zweiten Kontaktfahnen 17a und 18a zu erzeugen.

Das Steckelement 21 ist nagelartig ausgebildet, weist einen Kopf 21a und einen sich daran anschließenden Schaft 21b mit einer Spitze 21c auf. Es ist stellvertretend für weitere gezeigt und durch eine zweite Öffnung 20a eines zweiten Öffnungsabschnitts 20 des Gehäuses 4 an dessen Unterseite hindurch zwischen die zweiten Druckfedern 17 und 18 gesteckt. Die Spitze 21c dient beim Einstecken zum Einfädeln und Auseinanderdrücken der zweiten Kontaktfahnen 17a und 18a der zweiten Druckfedern 17 und 18 und ist im eingesteckten Zustand in dem Trennelement 22 aufgenommen, welches dazu analog zur Stiftspitze 24c des Stiftelementes 24 eine Aufnahme aufweist, die mit der Spitze 21c korrespondiert. Im eingesteckten Zustand ruhen die zweiten Druckfedern 17 und 18 mit ihren durch das Steckelement 21 getrennten Kontaktabschnitten an dem Schaft 21b, welcher elektrisch isolierend ausgebildet ist.

Um das Steckelement 21 unlösbar oder nur aufwendig lösbar in der Anschlussvorrichtung 3 zu verrasten, weist es ein Verrastmittel 21d auf, welches mit einem Gegenverrastmittel, welches hier das Gehäuse 4 der Anschlussvorrichtung 3 ist, verrastet. Das Verrastelement ist hier als Schnappzunge ausgebildet, die einstückig am Steckelement 21 angeformt ist. Zudem ist das Steckelement 21 bei montierter Anschlussvorrichtung 3 von der Tragschiene 25 überdeckt und daher unzugänglich angeordnet.

Durch die ersten und zweiten Kammern 11, 12 und 13, 14 ist die Anschlussvorrichtung 3 nicht nur für die Verwendung zur Montage auf Tragschienen 25 geeignet, sondern auch für andere Montagearten, wie in Figur 2 in einer schematische Schnittansicht eines zweiten Ausführungsbeispiels der erfindungsgemäßen Anordnung 1 dargestellt ist.

Die Anschlussvorrichtung 3 ist hierbei mit ihrer Unterseite auf einer Seite an einem Wandelement 26 mit Wandöffnungen 26a und Wandausschnitten 26b angebracht. Die Auflagen 4a des Gehäuses 4 treten durch die Wandöffnungen 26a hindurch, wobei der zweite Öffnungsabschnitt 20 des Gehäuses 4 an dessen Unterseite durch den Wandausschnitt 26b hervortritt.

Die Prüfvorrichtung 2 ist auf der anderen Seite des Wandelementes 26 angeordnet, wobei ihr Stiftelement 24 durch die zweite Öffnung 20a des zweiten Öffnungsabschnitts 20 zwischen die zweiten Kontaktfahnen 17a und 18a der zweiten Druckfedern 17 und 18 der zweiten Kammern 13 und 14 eingesteckt ist. Die Prüfvorrichtung 2 ist somit auf der Unterseite der Anschlussvorrichtung 3 in diese eingesteckt. Dabei ruhen die Auflagen 4a der Anschlussvorrichtung 3 auf der Unterseite der Prüfvorrichtung 2, so dass die Prüfvorrichtung 2 und die Anschlussvorrichtung 3 definiert voneinander beabstandet sind.

Das Steckelement 21 ist in diesem zweiten Ausführungsbeispiel von der Oberseite der Anschlussvorrichtung 3 durch den ersten Öffnungsabschnitt 19 zwischen die ersten Kontaktfahnen 15a und 16a der ersten Druckfedern 15 und 16 zur Trennung derselben eingesteckt.

Die weiteren Funktionselemente und -gruppen sind bereits im Zusammenhang mit Figur 1 beschrieben.

Somit kann die Anschlussvorrichtung 3 beidseitig mit der Prüfvorrichtung 2 zusammengesteckt werden.

Ist die Anschlussvorrichtung 3 für Tragschienenmontage vorgesehen, wird sie mit den Steckelementen 21 von der Unterseite her bestückt. Bei z.B. einer Wandmontage, bei welcher die Anschlussvorrichtung 3 am besten von der Unterseite her zugänglich ist, werden die Steckelemente 21 von der Oberseite der Anschlussvorrichtung 3 eingesetzt.

Figur 3 zeigt eine schematische Schnittansicht des zweiten Ausführungsbeispiels nach Figur 2 mit ersten und zweiten Kontaktfahnen 15a, 16a, 17a, 18a.

Die ersten und zweiten Kontaktfahnen 15a, 16a und 17a, 18a stehen sich jeweils als Paare zwischen den ersten Druckfedern 15 und 16 und den zweiten Druckfedern 17, 18 gegenüber. Die zweiten Kontaktfahnen 15a und 16a kontaktieren sich, da noch kein Steckelement 21 eingesteckt ist. Die ersten und zweiten Kontaktfahnen 15a, 16a und 17a, 18a weisen Federabschnitte 15b, 16b, 17b, 18b auf, mit welchen sie jeweils auf den Stromschienen 6 und 8 elektrisch leitend befestigt sind. Daher sind jeweils die spiegelbildlich der Stromschienen 6, 8 einander gegenüber liegenden Kontaktfahnen 15a, 17a und 16a, 18a durch die Stromschienen 6, 8 elektrisch kontaktierend miteinander verbunden. Mit anderen Worten sind die Kontaktfahnen 15a und 17a mit der Stromschiene 6 verbunden, und die Kontaktfahnen 16a und 18a sind an die Stromschiene 8 angeschlossen.

In der Figur 3 sind die oberen, ersten Kontaktfahnen 15a und 16a ohne Steckelement 21 dargestellt, wobei die unteren, zweiten Kontaktfahnen 17a und 18a durch das Stiftelement 24 auseinandergedrückt sind.

Figur 4 zeigt eine schematische Perspektivansicht eines Ausführungsbeispiels einer erfindungsgemäßen Anschlussvorrichtung 3 mit einem Manipulationsschutz in einer ersten Stellung und Figur 5 zeigt diesen Manipulationsschutz in einer zweiten Stellung.

Wie bereits oben beschrieben weist die Anschlussvorrichtung 3 in diesem Ausführungsbeispiel sieben nebeneinander angeordnete Klemm- bzw. Anschlusseinheiten 300 auf. In den Figuren 4 und 5 sind die ersten Öffnungsabschnitte 19 mit den ersten Öffnungen 19a zu erkennen. In dieser Ausführung sind die ersten Druckfedern 15, 16 mit Kontaktfahnen 15a, 16a zusammenwirkend angeordnet, von denen nur die mit den ersten Druckfedern 16 zusammenwirkenden Kontaktfahnen 16a zu sehen sind.

In dem Gehäuse 4 der Anschlussvorrichtung 3 sind auf beiden Längsseiten über den Klemmeinheiten 5, 7 (die nicht sichtbar sind), längliche Schutzelemente 27 angeordnet, die in Führungen 4c des Gehäuses 4 in Längsrichtung der Anschlussvorrichtung 3 längsverschiebbar gehalten sind. Die Schutzelemente 27 sind gegenläufig angeordnet. Die Schutzelemente 27 befinden sich in der ersten, geschlossenen Stellung, d.h. die Betätigungsabschnitte 9 und 10 der Klemmeinheiten 5, 7 befinden sich unterhalb der Schutzelemente 27 und sind nicht zugänglich.

In der geschlossenen Stellung liegen die Betätigungsteile 27a der Schutzelemente 27 mit einer Kante an einem Anschlag 4d des Gehäuses 4 an.

Die Schutzelemente 27 weisen pro Klemmeinheit 5, 7 jeweils ein Abdeckfeld 27c mit einer Abdecköffnung 27d auf. Damit die Betätigungsabschnitte 9 und 10 der Klemmeinheiten zugänglich gemacht werden können, sind die Schutzelemente 27 in den Pfeilrichtungen gegenläufig mittels eines Werkzeugs 28 über ihre Betätigungsteile 27a in die zweite Stellung verschiebbar.

Die Klemmeinheiten 5, 7 sind hier als Zugbügelanschlüsse ausgebildet (s. Fig. 1). Die Erfindung ist aber nicht auf diese Ausbildung beschränkt. Sondern die Klemmeinheiten 5, 7 können auch mit einer anderen Anschlusstechnik ausgeführt sein, beispielsweise als Zugfederanschlüsse.

Optional bietet die erfindungsgemäße Anschlussvorrichtung 3 die Möglichkeit, mehrere Klemmeinheiten 5, 7 über Querverbinder 70 miteinander elektrisch zu verbinden. Die Querverbinder 70 werden, wie die Fig. 4(b) zeigt, während des Montageprozesses unterhalb der Schutzelemente 27 in die Betätigungsabschnitte 9, 10 in eine Einsteckrichtung 700 eingesteckt, so dass jeweils ein Steckkontakt 71 des Querverbinders 70 in einen Betätigungsabschnitt 9, 10 eingreift und der Querverbinder 70 die Betätigungsabschnitte 9, 10, in die die Steckkontakte 71 eingesteckt sind, elektrisch miteinander verbindet. Das Schutzelement 27 wird nach dem Einstecken des Querverbinders 70 in die Führungen 4c eingeschoben, so dass der Querverbinder 70 im Auslieferungszustand der Anschlussvorrichtung 3 unzugänglich ist.

In der in Figur 5 gezeigten zweiten Stellung sind die Schutzelemente 27 so verschoben, dass die Abdecköffnungen 27d der Abdeckfelder 27c über den Betätigungsabschnitten 9 und 10 der Klemmeinheiten 5, 7 angeordnet sind und ein Zugriff auf die Klemmeinheiten 5, 7 z.B. mit dem Werkzeug (Schraubendreher) möglich ist. Dabei sind die Betätigungsteile 27a der Schutzelemente 27 in einem Abstand von den Anschlägen 4d des Gehäuses 4 angeordnet.

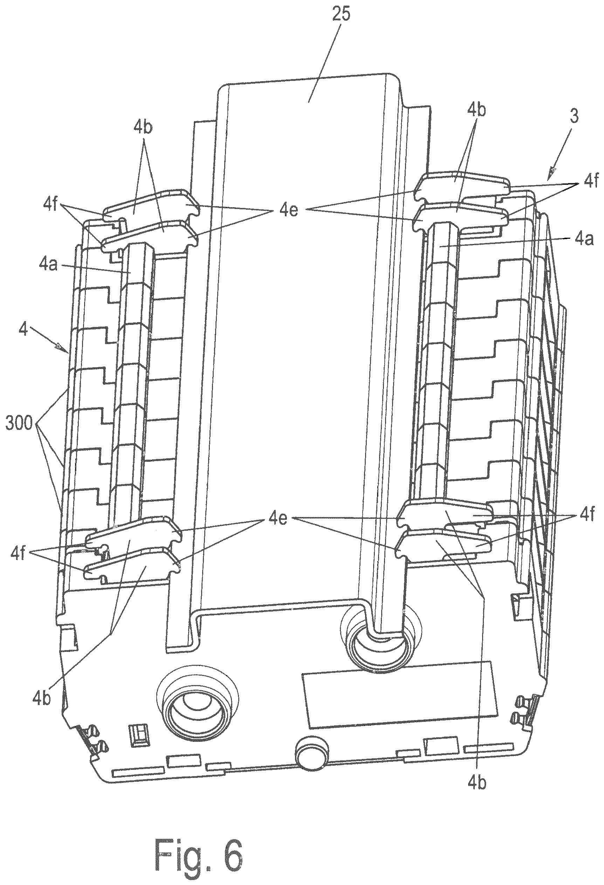

Figur 6 zeigt eine schematische Perspektivansicht eines Ausführungsbeispiels der erfindungsgemäßen Anschlussvorrichtung 3 bei Tragschienenmontage von unten.

In diesem Ausführungsbeispiel sind in vier Eckbereichen an der Unterseite des Gehäuses 4 der Anschlussvorrichtung 3 jeweils doppelte Halter 4b in das Gehäuse 4 eingesteckt bzw. eingerastet. Jeder Halter 4b weist ein nach innen zur Tragschiene 25 weisendes Ende mit einem Tragschienenhalteabschnitt 4e in Form einer Nase auf. An den anderen Enden, welche jeweils nach außen weisen, sind die Halter 4b mit armförmigen Wandhalteabschnitten 4f ausgebildet.

Bei der in Figur 6 gezeigten Montage der Anschlussvorrichtung 3 auf der Tragschiene 25 wird die Anschlussvorrichtung 3 mittels der Tragschienenhalteabschnitt 4e der Halter 4b an der Tragschiene 25 gehalten, indem die Tragschienenhalteabschnitt 4e einen Abschnitt der Tragschiene 25 übergreifen. Dazu können die Halter 4b z.B. nach aufgebrachter Anschlussvorrichtung 3 in diese in entsprechende Ausnehmungen des Gehäuses 4 in die gezeigte Position eingesteckt bzw. eingerastet werden oder in Richtung Tragschiene 25 aufeinander zu geschoben werden, um das Übergreifen der Tragschienenhalteabschnitt 4e zu schaffen. Die Anschlussvorrichtung 3 kann aber auch in Längsrichtung der Tragschiene 25 auf diese aufgeschoben werden. Andere Möglichkeiten sind natürlich denkbar.

Die Halter 4b weisen mittels der Wandhalteabschnitten 4f eine weitere Haltefunktion auf, die in Figur 7 dargestellt ist.

Figur 7 zeigt eine schematische Perspektivansicht eines Ausführungsbeispiels der erfindungsgemäßen Anschlussvorrichtung 3 bei Wandmontage von unten.

In diesem Ausführungsbeispiel ist die Anschlussvorrichtung 3 mit ihrer Unterseite in einen Wandausschnitt 26b des Wandelementes 26 (siehe auch Figur 2) eingesetzt. Die nach außen weisenden Wandhalteabschnitte 4f der Halter 4b übergreifen hier einen Rand des Wandausschnitts 26b des Wandelementes 26 und halten und befestigen so die Anschlussvorrichtung 3 an dem Wandelement 26. Zur Montage können die Halter 4b beispielsweise in entsprechende Öffnungen an der Unterseite des Gehäuses 4 eingesteckt und verrastet werden.

In Figur 7 ist die Unterseite der Anschlussvorrichtung 3 mit dem zweiten Öffnungsabschnitt 20 und den zweiten Öffnungen 20a zum Einstecken der Prüfvorrichtung 2 (siehe Figur 2) deutlich zu erkennen. Außerdem sind die Enden der zweiten Kontaktfahnen 17a und 18a zu sehen.

Die Halter 4b ermöglichen somit eine Montage der Anschlussvorrichtung 3 sowohl auf einer Tragschiene 25 als auch an einem Wandausschnitt 26b eines Wandelementes 26.

Durch das beschriebene Ausführungsbeispiel wird die Erfindung nicht eingeschränkt. Sie ist im Rahmen der angefügten Ansprüche natürlich modifizierbar.

Es ist denkbar, dass die Druckfedern 15, 16 und 17, 18 an ihren Kontaktstellen mit Kontaktabschnitten aus speziellem Kontaktmaterial versehen sind oder mit den Kontaktfahnen 15a, 16a, 17a, 18a zusammenwirken.

### Bezugszeichen

- 1: Anordnung
- 2: Prüfvorrichtung
- 3: Anschlussvorrichtung
- 333: Längsrichtung / Längserstreckung der Anschlussvorrichtung
- 300: Anschlusseinheit
- 4: Gehäuse
- 4a: Fuß
- 4b: Halter
- 4c: Führung
- 4d: Anschlag
- 4e: Tragschienenhalteabschnitt
- 4f: Wandhalteabschnitt
- 5,7: Klemmeinheit
- 6,8: Stromschiene
- 9, 10: Betätigungsabschnitt
- 11, 12: Erste Kammern
- 13, 14: Zweite Kammer
- 15, 16: Erste Druckfeder
- 15a, 16a: Erste Kontaktfahne
- 15b, 16b: Federabschnitt
- 17, 18: Zweite Druckfeder
- 17a, 18a: Zweite Kontaktfahne
- 17b, 18b: Federabschnitt
- 19: Erster Öffnungsabschnitt
- 19a: Erste Öffnung
- 20: Zweiter Öffnungsabschnitt
- 20a: Zweite Öffnung
- 21: Steckelement
- 21a: Kopf
- 21b: Schaft
- 21c: Spitze
- 22: Trennelement
- 23: Prüfvorrichtungsgehäuse
- 24: Stiftelement
- 24a: Verbindung
- 24b: Stiftkörper
- 24c: Stiftspitze
- 25: Tragschiene
- 26: Wandelement
- 26a: Wandöffnung
- 26b: Wandausschnitt
- 27: Schutzelement
- 27a: Betätigungsteil
- 27b: Ausnehmung
- 27c: Abdeckfeld
- 27d: Abdecköffnung
- 28: Werkzeug
- 70: Querverbinder
- 71: Steckkontakt
- 700: Einsteckrichtung

## Patentansprüche

1. Prüf- und Anschlussvorrichtungsanordnung (1), mit
einer Prüfvorrichtung (2); und
einer Anschlussvorrichtung (3) zum Anschluss von elektrischen Leitern,
wobei die Prüfvorrichtung (2) in die Anschlussvorrichtung (3) einsteckbar ist und dabei eine elektrische Verbindung zwischen zwei sich elektrisch kontaktierenden Kontaktfahnen (15a, 16a, 17a, 18a) trennt,
**dadurch gekennzeichnet,**
**dass** die Prüfvorrichtung (2) entweder von einer Oberseite der Anschlussvorrichtung (3) oder von einer Unterseite der Anschlussvorrichtung (3) in die Anschlussvorrichtung (3) eingesteckt ist, wobei die Anschlussvorrichtung (3) sowohl an ihrer Oberseite als auch an ihrer Unterseite zwei sich elektrisch kontaktierende Kontaktfahnen (15a, 16a, 17a, 18a) aufweist und dass ein elektrisch isolierendes Steckelement (21) vorgesehen ist, das bei von der Oberseite der Anschlussvorrichtung (3) in diese eingesteckter Prüfvorrichtung (2) die an der Unterseite der Anschlussvorrichtung angeordneten sich elektrisch kontaktierenden Kontaktfahnen (15a, 16a, 17a, 18a) elektrisch trennt, und dass das Steckelement (21) bei von der Unterseite der Anschlussvorrichtung (3) in diese eingesteckter Prüfvorrichtung (2) die an der Oberseite der Anschlussvorrichtung (3) angeordneten sich elektrisch kontaktierenden Kontaktfahnen (15a, 16a, 17a, 18a) elektrisch trennt.

2. Prüf- und Anschlussvorrichtungsanordnung nach Anspruch 1, **dadurch gekennzeichnet, dass** die zwei an der Oberseite angeordneten und die zwei an der Unterseite angeordneten Kontaktfahnen (15a, 16a, 17a, 18a) übereinander angeordnet sind.

3. Prüf- und Anschlussvorrichtungsanordnung nach Anspruch 2, **dadurch gekennzeichnet, dass** die zwei an der Oberseite angeordneten und die zwei an der Unterseite angeordneten Kontaktfahnen (15a, 16a, 17a, 18a) elektrisch parallel geschaltet sind.

4. Prüf- und Anschlussvorrichtungsanordnung nach einem der vorherigen Ansprüche, **dadurch gekennzeichnet, dass** das Steckelement (21) unlösbar in die Anschlussvorrichtung (3) eingesteckt ist.

5. Prüf- und Anschlussvorrichtungsanordnung nach einem der vorhergehenden Ansprüche, **dadurch gekennzeichnet, dass** die Anschlussvorrichtung (3) mindestens ein Schutzelement (27) aufweist, welches aus einer ersten Stellung, in welcher es Betätigungsabschnitte (9, 10) für darunter angeordnete Klemmeinheiten (5, 7) der Anschlussvorrichtung (3) verschließt, in eine zweite Stellung verstellbar ist, in welcher die Betätigungsabschnitte (9, 10) zugänglich sind.

6. Prüf- und Anschlussvorrichtungsanordnung nach Anspruch 5, **dadurch gekennzeichnet, dass** das mindestens eine Schutzelement (27) in einer Führung (4a) eines Gehäuses (4) der Anschlussvorrichtung (3) in Längsrichtung der Anschlussvorrichtung (3) verschiebbar gehalten ist.

7. Prüf- und Anschlussvorrichtungsanordnung nach Anspruch 5 oder 6, **dadurch gekennzeichnet, dass** das mindestens eine Schutzelement (27) jeweils ein Abdeckfeld (27c) mit einer Abdecköffnung (27d) pro Klemmeinheit (5, 7) aufweist.

8. Prüf- und Anschlussvorrichtungsanordnung nach einem der vorhergehenden Ansprüche, **dadurch gekennzeichnet, dass** die Anschlussvorrichtung (3) für eine Tragschienenmontage und/oder eine Wandmontage vorgesehen ist.

9. Prüf- und Anschlussvorrichtungsanordnung nach Anspruch 8, **dadurch gekennzeichnet, dass** die Anschlussvorrichtung (3) mindestens zwei anbringbare Halter (4b) aufweist, welche jeweils Tragschienenhalteabschnitte (4e) für die Tragschienenmontage der Anschlussvorrichtung (3) und Wandhalteabschnitte (4f) für die Wandmontage der Anschlussvorrichtung (3) aufweisen.

## Claims

1. An arrangement of a testing device and a connection device (1), with a testing device (2); and
a connection device (3) for the connecting of electrical conductors, wherein the testing device (2) can be plugged into the connection device (3) and, in so doing, interrupts an electrical connection between two contact tabs (15a, 16a, 17a, 18a) that electrically contact with each other, **characterized in that**
the testing device (2) is plugged into the connection device (3) either from an upper side of the connection device (3) or from a lower side of the connection device (3), wherein the connection device (3) has two contact tabs (15a, 16a, 17a, 18a) that electrically contact with each other both on its upper side and on its lower side and that an electrically isolating plug element (21) is provided, which, with the testing device (2) being plugged into the connection device (3) from the upper side of it, electrically interrupts the contact tabs (15a, 16a, 17a, 18a) that are electrically contacting with each other and that are arranged on the lower side of the connection device, and that, with the testing device (2) being plugged into the connection device (3) from the lower side of it, the plug element (21) electrically interrupts the contact tabs (15a, 16a, 17a, 18a) that are electrically contacting with each other and that are arranged on the upper side of the connection device (3).

2. An arrangement of a testing device and a connection device according to Claim 1, **characterized in that** the two contact tabs, which are arranged on the upper side, and the two contact tabs, which are arranged on the lower side (15a, 16a, 17a, 18a), are arranged as one on top of the other.

3. An arrangement of a testing device and a connection device according to Claim 2, **characterized in that** the two contact tabs, which are arranged on the upper side, and the two contact tabs, which are arranged on the lower side (15a, 16a, 17a, 18a), are electrically connected in parallel.

4. An arrangement of a testing device and a connection device according to one of the aforementioned claims, **characterized in that** the plug element (21) is plugged into the connection device (3) in a non-detachable manner.

5. An arrangement of a testing device and a connection device according to one of the aforementioned claims, **characterized in that** the connection device (3) has at least one protective element (27), which can be adjusted from a first position in which it locks actuating sections (9, 10) for clamping units (5, 7) of the connection device (3) that are arranged under them into a second position in which the actuating sections (9, 10) are accessible.

6. An arrangement of a testing device and a connection device according to Claim 5, **characterized in that** at least one protective element (27) is movably housed in a guide (4a) of a housing (4) of the connection device (3) in the longitudinal direction of the connection device (3).

7. An arrangement of a testing device and a connection device according to Claim 5 or 6, **characterized in that** the at least one protective element (27) has one covering area (27c) each with a covering opening (27d) per clamping unit (5, 7).

8. An arrangement of a testing device and a connection device according to one of the aforementioned claims, **characterized in that** the connection device (3) is intended for a mounting with a mounting rail and/or wall mounting.

9. An arrangement of a testing device and a connection device according to Claim 8, **characterized in that** the connection device (3) has at least two supports (4b) that can be fastened, each of which has mounting rail holding sections (4e) for the mounting of the connection device (3) on a mounting rail and wall holding sections (4f) for the mounting of the connection device (3) on a wall.

## Revendications

1. Disposition de dispositifs de test et de raccordement (1), avec
un dispositif de test (2) et
un dispositif de raccordement (3) pour le raccordement de conducteurs électriques,
dans lequel le dispositif de test (2) peut être enfiché dans le dispositif de raccordement (3) et coupe ainsi une connexion électrique entre deux languettes de contact (15a, 16a, 17a, 18a) en contact électrique l'une avec l'autre, **caractérisée en ce que** le dispositif de test (2) est enfiché dans le dispositif de raccordement (3) soit par une face supérieure du dispositif de raccordement (3), soit par une face inférieure du dispositif de raccordement (3), le dispositif de raccordement (3) présentant aussi bien sur sa face supérieure que sur sa face inférieure deux languettes de contact (15a, 16a, 17a, 18a) qui viennent en contact l'une avec l'autre, et **en ce qu'**il est prévu un élément enfichable isolant électrique (21) qui, lorsque le dispositif de test (2) est enfiché dans le dispositif de raccordement (3) par la face supérieure de celui-ci, sépare électriquement les languettes de contact (15a, 16a, 17a, 18a) qui viennent en contact l'une avec l'autre disposées sur la face inférieure du dispositif de raccordement et **en ce que** l'élément enfichable (21) sépare électriquement, lorsque le dispositif de test (2) est enfiché dans le dispositif de raccordement (3) par la face inférieure de celui-ci, les languettes de contact (15a, 16a, 17a, 18a) qui viennent en contact l'une avec l'autre disposées sur la face supérieure du dispositif de raccordement.

2. Disposition de dispositifs de test et de raccordement selon la revendication 1, **caractérisée en ce que** les deux languettes de contact (15a, 16a, 17a, 18a) disposées sur la face supérieure et les deux disposées sur la face inférieure sont disposées les unes au-dessus des autres.

3. Disposition de dispositifs de test et de raccordement selon la revendication 2, **caractérisée en ce que** les deux languettes de contact (15a, 16a, 17a, 18a) disposées sur la face supérieure et les deux disposées sur la face inférieure sont montées électriquement en parallèle.

4. Disposition de dispositifs de test et de raccordement selon l'une des revendications précédentes, **caractérisée en ce que** l'élément enfichable (21) est enfiché de façon inamovible dans le dispositif de raccordement (3).

5. Disposition de dispositifs de test et de raccordement selon l'une des revendications précédentes, **caractérisée en ce que** le dispositif de raccordement (3) présente au moins un élément de protection (27) qui peut être déplacé d'une première position, dans laquelle il ferme des sections d'actionnement (9, 10) pour des unités de borne (5, 7) du dispositif de raccordement (3) disposées en dessous, à une deuxième position dans laquelle les sections d'actionnement (9, 10) sont accessibles.

6. Disposition de dispositifs de test et de raccordement selon la revendication 5, **caractérisée en ce que** l'au moins un élément de protection (27) est retenu avec possibilité de translation dans le sens de la longueur du dispositif de raccordement (3) dans un guide (4a) d'un boîtier (4) du dispositif de raccordement (3).

7. Disposition de dispositifs de test et de raccordement selon la revendication 5 ou 6, **caractérisée en ce que** l'au moins un élément de protection (27) présente un panneau de couverture (27c) avec une ouverture de couverture (27d) pour chaque unité de borne (5, 7).

8. Disposition de dispositifs de test et de raccordement selon l'une des revendications précédentes, **caractérisée en ce que** le dispositif de raccordement (3) est prévu pour un montage sur rail porteur et/ou pour un montage mural.

9. Disposition de dispositifs de test et de raccordement selon la revendication 8, **caractérisée en ce que** le dispositif de raccordement (3) présente au moins deux fixations (4b) pouvant être montées, qui présentent chacune des parties de fixation sur rail porteur (4e) pour le montage du dispositif de raccordement (3) sur un rail porteur et des parties de fixation murale (4f) pour le montage mural du dispositif de raccordement (3).
